# EUROPÄISCHE PATENTSCHRIFT

(11) **EP 2 446 526 B1**
(45) Veröffentlichungstag und Bekanntmachung des Hinweises auf die Patenterteilung: **06.01.2016**
(21) Anmeldenummer: 10739939.6
(22) Anmeldetag: 05.08.2010
(51) Int. Cl.: H02J 7/34, H02J 15/00, H03K 5/24, H05B 33/08

(54) **SCHALTUNGSANORDNUNG ZUM BETREIBEN MINDESTENS EINER LED**
CIRCUIT ARRANGEMENT FOR OPERATING AT LEAST ONE LED
CIRCUITERIE POUR FAIRE FONCTIONNER AU MOINS UNE DIODE ÉLECTROLUMINESCENTE (DEL)

(30) Priorität: 21.09.2009 DE 102009042419
(43) Veröffentlichungstag der Anmeldung: 02.05.2012
(73) Patentinhaber: OSRAM GmbH, 80807 München (DE)
(72) Erfinder: FISCHER, Klaus, 86316 Friedberg (DE)
(86) Internationale Anmeldenummer: PCT/EP2010/061418
(87) Internationale Veröffentlichungsnummer: WO 2011/045097

(56) Entgegenhaltungen:
- EP-A1- 0 704 956
- EP-A1- 1 868 284
- US-B1- 6 233 165
- "CAPITOLO 15: AMPLIFICATORI OPERAZIONALI" In: JACOB MILLMAN: "CIRCUITI E SISTEMI MICROELETTRONICI" 30. Juni 1985 (1985-06-30), BORINGHIERI , TORINO (IT) , XP002608268 , Seiten 595-616 * 15.6 Tecniche di progetto di circuiti analogici (continuazione) - carichi attivi *; Seite 609 - Seite 611

## Beschreibung

### Technisches Gebiet

Die vorliegende Erfindung betrifft eine Schaltungsanordnung zum Betreiben mindestens einer LED mit einem Eingang mit einem ersten und einem zweiten Eingangsanschluss zum Koppeln mit einer Versorgungsgleichspannung, einem Ausgang mit einem ersten und einem zweiten Ausgangsanschluss zum Koppeln mit der mindestens einen LED, einem Spannungswandler mit einer Wandlerdrossel, einer Wandlerdiode und einem Wandlerschalter, wobei der Eingang des Spannungswandlers mit dem Eingang der Schaltungsanordnung und der Ausgang des Spannungswandlers mit dem Ausgang der Schaltungsanordnung gekoppelt ist, und einer Steuervorrichtung für den Wandlerschalter.

### Stand der Technik

Die vorliegende Erfindung betrifft insbesondere Treiberschaltungen, die aus der üblichen Netzspannung, beispielsweise 100 V oder 230 V, eine Stromversorgung für mindestens eine LED erzeugen. Die EP 0 704 956 A1 offenbart eine solche Treibschaltung. Aus dem Stand der Technik ist die Verwendung einer als Tiefsetzsteller bezeichneten Schaltungstopologie für die Treiberschaltung bekannt. Derartige Tiefsetzsteller werden im so genannten Discontinuous-Mode, das heißt mit Lücken im Drosselstrom, oder im Continuous-Mode, das heißt ohne Lücken im Drosselstrom, betrieben.

Bei Systemen, bei denen der Schalttransistor pro Zyklus für eine jeweils konstante Zeit eingeschaltet wird, muss die Wandlerdrossel so ausgelegt werden, dass sie keinesfalls in Sättigung gerät. Dies führt zu einer tendenziellen Überdimensionierung dieses Bauteils. Da die Abmagnetisierungszeit der Wandlerdrossel von der Eingangsspannung abhängt, muss ein fixes Abmagnetisierungsintervall, das heißt eine konstante Ausschaltzeit des Transistors, so groß gewählt sein, dass der Drosselstrom in jedem Fall auf Null sinkt, bevor der Schalttransistor erneut eingeschaltet wird. Dies führt zu Lücken im Stromfluss der Wandlerdrossel und damit zu einer ineffizienten Nutzung der Bauelemente.

### Darstellung der Erfindung

Die Aufgabe der vorliegenden Erfindung besteht deshalb darin, eine gattungsgemäße Schaltungsanordnung derart weiterzubilden, dass eine möglichst effiziente Nutzung der Bauelemente ermöglicht wird.

Diese Aufgabe wird gelöst durch eine Schaltungsanordnung mit den Merkmalen von Patentanspruch 1.

Erfindungsgemäß wird zur Steuerung des Schalttransistors eine bevorzugt aus diskreten Bauelementen aufgebaute Schaltungsanordnung vorgesehen, bei der einerseits während der Aufmagnetisierung der Drossel der Strom durch den Wandlerschalter gemessen wird, um bei Erreichen eines vorgebbaren Maximalwerts für diesen Strom ein Ausschalten des Transistors zu ermöglichen, und bei der andererseits die Abmagnetisierung der Drossel schaltungstechnisch erfasst wird, um ein sofortiges Wiedereinschalten des Transistors zu erreichen. Durch diese Maßnahmen werden Lücken im Stromfluss der Drossel vermieden, was zu einer äußerst effizienten Nutzung der Bauelemente führt. Durch den Verzicht auf integrierte Bausteine lässt sich die der Erfindung zugrunde liegende Aufgabe überdies sehr kostengünstig realisieren. Damit kann die Bereitstellung eines sehr konstanten Ausgangsstroms auch bei Lampen mit geringer elektrischer Leistung ermöglicht werden, bei denen der Preisfaktor keine aufwändigen Lösungen zulässt.

Bevorzugt umfasst der Komparator einen Differenzverstärker, wobei die Last des Differenzverstärkers einen Stromspiegel umfasst, wobei auf der Ausgangsseite des Differenzverstärkers zwischen den ausgangsseitigen Schalter des Differenzverstärkers und den ausgangsseitigen Schalter des Stromspiegels ein erster ohmscher Widerstand gekoppelt ist, wobei der Ausgang des Komparators mit dem Verbindungspunkt des ausgangsseitigen Schalters des Differenzverstärkers und des ersten ohmschen Widerstands gekoppelt ist. Dadurch steigt die Spannung am Ausgang des Komparators sehr schnell an, wodurch eine besonders zuverlässige und schnelle Aktivierung der Ausschaltvorrichtung für den Wandlerschalter erreicht wird. Durch die Verwendung des ersten ohmschen Widerstands ist es daher möglich, die Reaktionszeit des Komparators deutlich zu erhöhen, weil die Ausgangsspannung des Komparators durch den zusätzlichen Spannungsabfall am ersten ohmschen Widerstand deutlich schneller über einen Schwellwert der Ausschaltvorrichtung steigt, bei dem ein Ausschaltsignal erzeugt wird.

Eine bevorzugte Ausführungsform zeichnet sich dadurch aus, dass die Schaltungsanordnung eine interne Spannungsversorgung, insbesondere mit einer Ladungspumpe, umfasst. Da es sich bei der Versorgungsgleichspannung üblicherweise um die gleichgerichtete Netzspannung handelt, bietet eine interne Spannungsversorgung den Vorteil, dass die gleichgerichtete Netzspannung nur einmal auf ein Niveau gebracht werden muss, das für die Versorgung der Steuervorrichtung ausgelegt ist. Die Verwendung einer Ladungspumpe bietet den Vorteil, dass bereits eine kleine Wechselspannung zum Nachladen der internen Spannungsversorgung Verwendung finden kann. Dadurch ergibt sich eine besonders ökonomische Auslegung der Schaltungsanordnung.

Bevorzugt umfasst die Sollwertvorrichtung einen Spannungsteiler, der mit der internen Spannungsversorgung gekoppelt ist, wobei dem Spannungsteiler einer erste Zenerdiode parallel geschaltet ist. Dadurch wird aus der internen Spannungsversorgung eine äußerst konstante Konstantspannung gebildet, die dem Spannungsteiler bereitgestellt wird, um dadurch den Sollwert für den Komparator zu bilden.

Besonders bevorzugt wird die Nennspannung der ersten Zenerdiode wie folgt gewählt: Nennspannung entweder 5,1 V oder 5,6 V und/oder Nennspannung ist kleiner als die interne Versorgungsspannung und/oder Nennspannung ist größer als die Einschaltschwelle des Wandlerschalters. Durch die zuerst genannte Wahl wird sichergestellt, dass die Temperaturabhängigkeit der Zenerspannung möglichst gering bleibt und damit thermische Effekte weitgehend vernachlässigbar bleiben. Durch die zweite Wahl wird erreicht, dass sich Schwankungen der Versorgungsspannung nicht auf die Ausgangsspannung des Spannungsteilers auswirken können. Schließlich wird durch die dritte Wahl erreicht, dass beim Anlauf der Schaltungsanordnung die Verluste in einem gegebenenfalls vorhandenen Anlaufwiderstand nicht zu groß sind. Bevorzugt ist es weiterhin, wenn dem Ausgang des Spannungsteilers ein erster Kondensator parallel geschaltet ist. Dieser ermöglicht auf einfache Weise die Unterdrückung von Störsignalen, insbesondere EMVbedingten Störsignalen.

Bei einer bevorzugten Ausführungsform ist zwischen die interne Spannungsversorgung und den Versorgungsanschluss des Komparators eine Serienschaltung einer zweiten Zenerdiode und eines zweiten ohmschen Widerstands gekoppelt. Durch diese Maßnahme ist es möglich, beim Anlauf der Schaltungsanordnung den Steueranschluss des Wandlerschalters über einen Anlaufwiderstand der Schaltungsanordnung über dessen Einschaltschwelle aufzuladen und ihn dadurch einzuschalten. Ohne die Verwendung der zweiten Zenerdiode würde die Komparatorschaltung den Anlaufwiderstand so stark belasten, dass die Schaltschwelle des Wandlerschalters nicht erreicht werden würde. Eine niederohmigere Auslegung des Anlaufwiderstands würde dieses Problem zwar ebenfalls lösen, wäre aber im Betrieb mit deutlich höheren Verlusten verbunden.

Bevorzugt ist die Nennspannung der zweiten Zenerdiode größer als die Einschaltschwelle des Wandlerschalters.

Der Wandlerschalter weist üblicherweise eine Arbeitselektrode, eine Bezugselektrode und eine Steuerelektrode auf. Besonders bevorzugt ist dabei zwischen den ersten Eingangsanschluss der Schaltungsanordnung und die Steuerelektrode des Wandlerschalters eine Serienschaltung eines dritten ohmschen Widerstands und eines vierten ohmschen Widerstands gekoppelt. Dadurch wird das Anlaufen der Schaltungsanordnung ermöglicht. Die Ausbildung des Anlaufwiderstands durch mindestens zwei separate ohmsche Widerstände bietet weitere Vorteile, zu denen weiter unten Stellung genommen wird.

Bevorzugt ist die Ausschaltvorrichtung als Komplementär-Darlingtonschaltung mit einem ersten und einem zweiten Transistor ausgebildet, wobei die Steuerelektrode eines ersten Transistors mit dem Ausgang des Komparators gekoppelt ist, wobei die Bezugselektrode des zweiten Transistors mit dem Ausgang der Ausschaltvorrichtung gekoppelt ist, wobei die Steuerelektrode des zweiten Transistors mit der Arbeitselektrode des ersten Transistors gekoppelt ist, wobei zwischen die Bezugselektrode und die Steuerelektrode des zweiten Transistors ein zweiter Kondensator gekoppelt ist. Übersteigt demnach das Potenzial am Ausgang des Komparators einen vorgebbaren Schwellwert, wird der erste Transistor der Komplementär-Darlingtonschaltung leitend. Über die erwähnte Verbindung wird der zweite Transistor der Komplementär-Darlingtonschaltung leitend und zieht das Potenzial an der Steuerelektrode des Wandlerschalters auf Masse. Dadurch wird der Wandlerschalter zuverlässig ausgeschaltet. Der zweite Kondensator dient dazu, die Steuerelektrode des zweiten Transistors kapazitiv mit seiner Bezugselektrode zu koppeln. Im Falle von Spannungssprüngen des Potenzials an der Bezugselektrode des ersten Transistors kann so ein unbeabsichtigtes Einschalten des zweiten Transistors verhindert werden.

Weiterhin bevorzugt ist der internen Spannungsversorgung die Serienschaltung einer ersten Diode und einer dritten Zenerdiode parallel geschaltet. Besonders bevorzugt ist zwischen eine Quelle für die interne Spannungsversorgung und den Verbindungspunkt der ersten Diode und der dritten Zenerdiode als Ladungspumpe die Serienschaltung eines dritten Kondensators und eines fünften ohmschen Widerstands gekoppelt. Generell gilt, sofern für eine Spannungsbegrenzung an anderer Stelle Maßnahmen getroffen werden, dass die zuvor und im Nachfolgenden erwähnten Zenerdioden durch Dioden und die entsprechenden anderen Maßnahmen zur Spannungsbegrenzung ersetzt werden können.

Die folgenden bevorzugten Ausführungsformen betreffen eine erste Variante einer erfindungsgemäßen Schaltungsanordnung. Diese zeichnet sich dadurch aus, dass die Steuervorrichtung eine zweite Induktivität umfasst, die mit der Wandlerdrossel magnetisch gekoppelt ist, wobei die zweite Induktivität eine Quelle einer Ladungspumpe für die interne Spannungsversorgung darstellt. Bevorzugt ist deshalb die zweite Induktivität über die Serienschaltung des dritten Kondensators und des fünften ohmschen Widerstands mit dem Verbindungspunkt der ersten Diode und der dritten Zenerdiode gekoppelt. Die dritte Zenerdiode legt demnach mit ihrer Zenerspannung die Höhe der internen Spannungsversorgung fest. Der dritte Kondensator arbeitet als Ladungspumpe. Dabei wird der ladende beziehungsweise entladende Strom des dritten Kondensators in einen Kondensator geleitet, der der Serienschaltung aus erster Diode und dritter Zenerdiode parallel geschaltet ist, wodurch dieser geladen wird.

Bevorzugt ist weiterhin ein dritter Transistor vorgesehen, wobei die Steuerelektrode des dritten Transistors mit dem Verbindungspunkt der Serienschaltung aus dem dritten Kondensator und dem fünften ohmschen Widerstand gekoppelt ist, wobei die Arbeitselektrode des dritten Transistors mit der internen Spannungsversorgung gekoppelt ist, wobei die Bezugselektrode des dritten Transistors mit der Steuerelektrode des Wandlerschalters gekoppelt ist. Weiterhin bevorzugt ist der Verbindungspunkt der ersten Diode und der dritten Zenerdiode mit dem Verbindungspunkt des Ausgangs der Ausschaltvorrichtung und der Steuerelektrode des dritten Transistors gekoppelt. Dies hat folgende Wirkungen: In dem Augenblick, in dem der Wandlerschalter durch die Ausschaltvorrichtung ausgeschaltet wird, kehrt sich die Polarität der Spannung über der zweiten Induktivität um. Dies hat zur Folge, dass durch die Ankopplung der zweiten Induktivität über den dritten Kondensator und den fünften ohmschen Widerstand das Potenzial an dem Knoten, mit dem die Anode der ersten Diode und die Kathode der dritten Zenerdiode verbunden sind, auf Null, d.h. auf Masse-Potential, sinkt. Dadurch wird die Steuerelektrode des Wandlerschalters auf MassePotenzial gezogen, wodurch der Wandlerschalter im ausgeschalteten Zustand gehalten wird.

In dem Augenblick, in dem die Wandlerdrossel vollständig abmagnetisiert ist, kehrt sich die Polarität der Spannung über der zweiten Induktivität abermals um, wodurch über den dritten Kondensator und den fünften ohmschen Widerstand das Potenzial an dem oben genannten Knoten wieder auf einen positiven Wert springt und damit, beschleunigt über eine den dritten Transistor umfassende Verstärkerstufe, der Wandlerschalter wieder eingeschaltet wird.

Bei einer zweiten Variante von erfindungsgemäßen Schaltungsanordnungen stellt die Arbeitselektrode des Wandlerschalters die Quelle einer Ladungspumpe für die interne Spannungsversorgung dar. Während bei der ersten Variante üblicherweise die Quelle der Ladungspumpe für die interne Spannungsversorgung durch eine Drossel mit zwei Wicklungen realisiert wird, zeichnet sich die zweite Variante durch eine deutlich kostengünstigere Realisierung und wesentlich geringere mechanische Abmessungen aus. Bei der zweiten Variante kann die Wandlerdrossel besonders kostengünstig und klein als Stabkerndrossel ausgeführt sein.

Bevorzugt ist dabei der Verbindungspunkt der ersten Diode und der dritten Zenerdiode über zumindest einen vierten Kondensator mit der Steuerelektrode eines dritten Transistors gekoppelt, wobei die Arbeitselektrode des dritten Transistors mit der Steuerelektrode des Wandlerschalters gekoppelt ist, wobei die Bezugselektrode des dritten Transistors mit der internen Spannungsversorgung gekoppelt ist. Dies führt dazu, dass ein Sprung des Potenzials am Verbindungspunkt der ersten Diode und der dritten Zenerdiode somit kapazitiv an die Steuerelektrode des dritten Transistors geleitet wird, wodurch dieser eingeschaltet wird, und damit die Steuerelektrode des Wandlerschalters an das Potenzial der internen Spannungsversorgung angekoppelt wird. Dadurch schaltet der Wandlerschalter ein.

Bevorzugt ist zwischen die interne Spannungsversorgung und die Steuerelektrode des dritten Transistors eine dritte Diode und/oder ein Anteil des vierten ohmschen Widerstands gekoppelt. Dabei dient die dritte Diode zum Schutz der Strecke Steuerelektrode-Bezugselektrode des dritten Transistors. Sie sorgt zusätzlich für einen symmetrischen Betrieb des den vierten Kondensator umfassenden RC-Gliedes. Der Anteil des vierten ohmschen Widerstands reduziert die Empfindlichkeit des dritten Transistors und sorgt dafür, dass der dritte Transistor nur bei Überschreiten einer Mindestsprunghöhe des Potenzials am Verbindungspunkt der ersten Diode und der dritten Zenerdiode eingeschaltet wird.

Der Wandlerschalter weist eine Steuerelektroden-Kapazität auf. In diesem Zusammenhang ist es weiter bevorzugt, wenn die Zeitkonstante aus dieser Steuerelektroden-Kapazität und dem Anteil des vierten ohmschen Widerstands, über den die Steuerelektrode des Wandlerschalters mit der internen Spannungsversorgung gekoppelt ist, größer ist als die maximale, im Betrieb auftretende Abmagnetisierungszeit der Wandlerdrossel. Diese Maßnahme stellt sicher, dass im selbstschwingenden Betrieb kein unbeabsichtigtes Einschalten des Wandlerschalters auftritt, bevor die Wandlerdrossel abmagnetisiert ist. Dies könnte nämlich vorkommen, wenn die Steuerelektrode des Wandlerschalters über den Anteil des vierten ohmschen Widerstands, über den die Steuerelektrode des Wandlerschalters mit der internen Spannungsversorgung gekoppelt ist, zu schnell aufgeladen wird.

Weiterhin bevorzugt ist der Verbindungspunkt der ersten Diode und der dritten Zenerdiode über die Serienschaltung eines fünften Kondensators und eines sechsten ohmschen Widerstands mit dem Eingang des Komparators gekoppelt, über den der Istwert des Stroms durch den Wandlerschalter zuführbar ist.

Weitere vorteilhafte Ausführungsformen ergeben sich aus den Unteransprüchen.

### Kurze Beschreibung der Zeichnung(en)

Im Nachfolgenden werden nunmehr Ausführungsbeispiele der vorliegenden Erfindung unter Bezugnahme auf die beigefügten Zeichnungen näher beschrieben. Es zeigen:
- Fig. 1: in schematischer Darstellung ein erstes Ausführungsbeispiel einer erfindungsgemäßen Schaltungsanordnung;
- Fig. 2: den zeitlichen Verlauf diverser elektrischer Größen während eines Ausschaltvorgangs des Wandlerschalters;
- Fig. 3: den zeitlichen Verlauf diverser elektrischer Größen während eines Einschaltvorgangs des Wandlerschalters; und
- Fig. 4: in schematischer Darstellung ein zweites Ausführungsbeispiel einer erfindungsgemäßen Schaltungsanordnung.

### Bevorzugte Ausführung der Erfindung

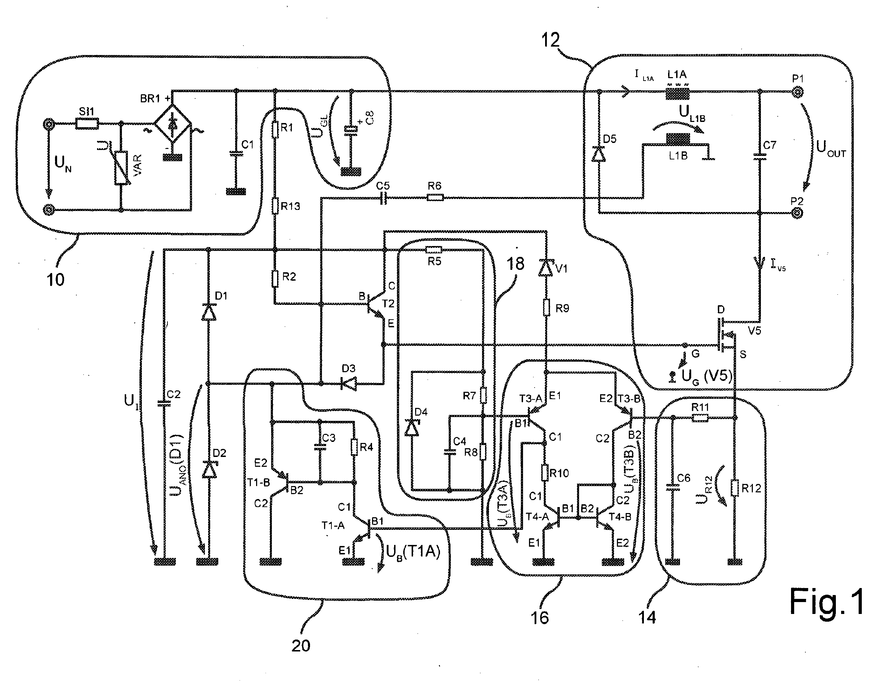

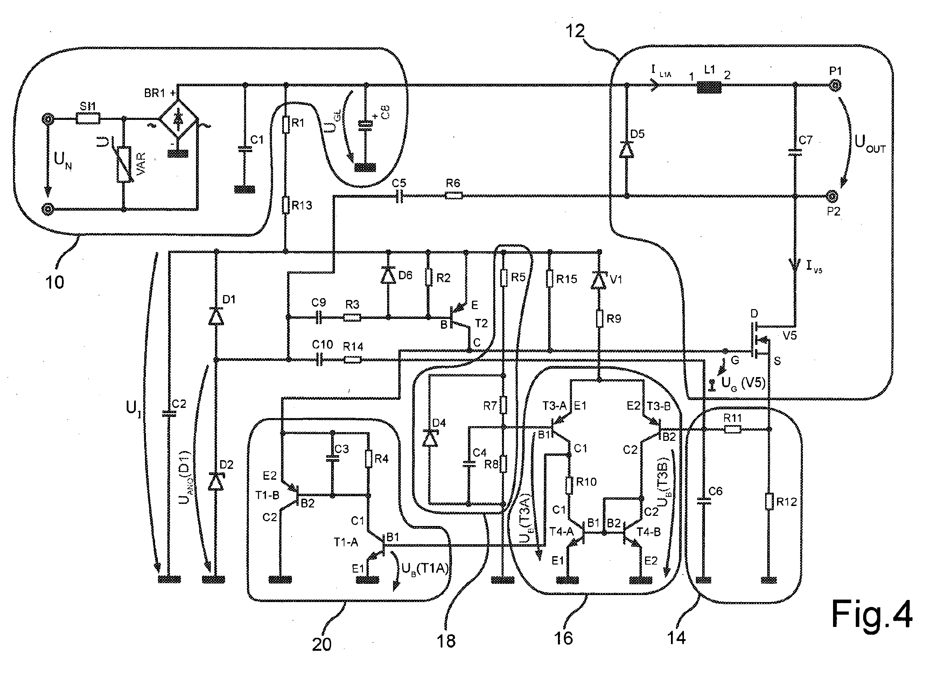

Fig. 1 zeigt in schematischer Darstellung ein erstes Ausführungsbeispiel einer erfindungsgemäßen Schaltungsanordnung. Die mit Bezug auf dieses Ausführungsbeispiel eingeführten Bezugszeichen gelten entsprechend für das in Fig. 4 dargestellte Ausführungsbeispiel, soweit gleiche und ähnliche Bauelemente betroffen sind. Insofern wird mit Bezug auf Fig. 4 lediglich auf die Unterschiede zum in Fig. 1 dargestellten Ausführungsbeispiel eingegangen.

Die in Fig. 1 dargestellte Schaltungsanordnung umfasst eine Eingangsstufe 10, an deren Eingang eine Netzspannung U_{N} angeschlossen werden kann und die an ihrem Ausgang eine gleichgerichtete Netzspannung U_{Gl} bereitstellt. Sie umfasst eine seriell zum Eingang angeordnete Sicherung SI1 sowie einen parallel zwischen die beiden Eingangsanschlüsse gekoppelten Varistor VAR. Es folgen ein Gleichrichter BR1 zur Gleichrichtung der Netzspannung U_{N} sowie zwei Glättungskondensatoren C1, C8. Die gleichgerichtete Netzspannung U_{Gl} wird einem Tiefsetzsteller 12 bereitgestellt, der eine Diode D5, eine Drossel L1A, eine mit der Drossel gekoppelte Induktivität L1B, einen Glättungskondensator C7 für den Ausgangsstrom I_{L1A}, sowie einen Schalttransistor V5 umfasst. Zwischen den Anschlüssen P1, P2 wird eine Ausgangsspannung Uₒᵤₜ an die mindestens eine LED bereitgestellt. Zur Steuerung des Schalttransistors V5 ist eine aus diskreten Bauelementen aufgebaute Steuervorrichtung vorgesehen, bei der einerseits während der Aufmagnetisierung der Drossel L1A der Strom I_{V5} durch den Schalttransistor V5 gemessen wird, um bei Erreichen eines vorgebbaren Maximalwerts für diesen Strom ein Ausschalten des Schalttransistors V5 zu ermöglichen, und bei der andererseits die Abmagnetisierung der Drossel L1A schaltungstechnisch erfasst wird, um ein sofortiges Wiedereinschalten des Schalttransistors V5 zu erreichen.

In die Source-Leitung des Schalttransistors V5 ist ein Sense-Widerstand R12 geschaltet, mit dem der Strom durch den Schalttransistor V5 gemessen wird. Mit einem Tiefpass bestehend aus dem Widerstand R11 und dem Kondensator C6 wird die am Widerstand R12 abfallende Spannung geglättet. Die entsprechende Baugruppe ist mit 14 bezeichnet.

Durch Erweiterung eines Differenzverstärkers, der die Transistoren T3-A und T3-B umfasst, um eine Ausgangsstufe, die einen Stromspiegel mit den Transistoren T4-A und T4-B umfasst, wird ein Komparator 16 gebildet, mit dem der aktuelle, geglättete Wert der Spannung U_{P12} am Sense-Widerstand R12 mit einem vorgebbaren Sollwert verglichen wird. Der Sollwert wird gebildet durch einen Spannungsteiler, der die Widerstände R7 und R8 sowie die Zenerdiode D4 umfasst. Dieser Spannungsteiler ist über einen Widerstand R5 mit der internen Versorgungsspannung U_{I} der Schaltungsanordnung verbunden. Diese Baugruppe ist mit 18 bezeichnet. Die Nennspannung der Diode D4 wird einerseits so gewählt, dass die Temperaturabhängigkeit der Zenerspannung möglichst gering bleibt und damit thermische Effekte weitgehend vernachlässigbar bleiben. Andererseits ist die Zenerspannung deutlich kleiner als die interne Versorgungsspannung U_{I}, so dass sich Schwankungen dieser Versorgungsspannung U_{I} nicht auf die Ausgangsspannung des Spannungsteilers auswirken können. Zusätzlich soll die Zenerspannung über der Einschaltschwelle des Schalttransistors V5 liegen, um beim Anlauf der Schaltungsanordnung den Anlaufwiderstand R1, R13 über den Widerstand R5 nicht zu stark zu belasten. Zur Unterdrückung von Störsignalen ist dem Ausgang des Spannungsteilers ein Glättungskondensator C4 parallel geschaltet.

Im Kollektorzweig des Transistors T4-A des Komparators 16 ist ein ohmscher Widerstand R10 vorgesehen. Dieser Widerstand R10 ermöglicht es, die Reaktionszeit des Komparators 16 deutlich zu verkürzen, weil die Ausgangsspannung des Komparators 16 durch den zusätzlichen Spannungsabfall am ohmschen Widerstand R10 deutlich schneller über den Schwellwert des angesteuerten Transistors T1-A der Ausschaltvorrichtung 20 steigt. Der Komparator 16 wird aus der internen Spannungsversorgung U_{I} über die Serienschaltung einer Zenerdiode V1 und eines ohmschen Widerstands R9 versorgt. Durch diese Maßnahme ist es möglich, beim Anlauf der Schaltungsanordnung den Steueranschluss des Schalttransistors V5 über den Anlaufwiderstand R1, R13 der Schaltungsanordnung über dessen Einschaltschwelle aufzuladen und ihn dadurch einzuschalten. Ohne die Verwendung der Zenerdiode V1 würde der Komparator 16 den Anlaufwiderstand R1, R13 so stark belasten, dass die Schaltschwelle des Schalttransistors V5 nicht erreicht werden würde. Eine niederohmigere Auslegung des Anlaufwiderstands R1, R13 würde dieses Problem zwar lösen, wäre aber im Betrieb mit deutlichen höheren Verlusten verbunden. Die Zenerspannung der Diode V1 liegt über der Einschaltschwelle des Schalttransistors V5.

Übersteigt das Potenzial an der Basis des Transistors T3-B, das proportional zum Strom durch den Schalttransistor V5 ist, dasjenige der Basis des Transistors T3-A, welches dem vorgebbaren, zulässigen Maximalwert für den Strom durch den Schalttransistor V5 entspricht, steigt die Spannung an der Basis des Transistors T1-A über dessen Schwellwert an. Dadurch wird der Transistor T1-A leitend. Durch das Leitendwerden des Transistors T1-A, dessen Kollektor direkt oder wie vorliegend über eine Verstärkerstufe mit dem Steueranschluss des Schalttransistors V5 verbunden ist, wird der Schalttransistor V5 ausgeschaltet. Die erwähnte Verstärkerstufe wird vorliegend gebildet durch einen weiteren Transistor T1-B, der zusammen mit dem Transistor T1-A eine Komplementär-Darlingtonschaltung bildet, den ohmschen Widerstand R4 und den Kondensator C3. Der Kondensator C3 ist erforderlich, um die

Basis des Transistors T1-B kapazitiv an den Emitter dieses Transistors anzukoppeln. Im Falle von Spannungssprüngen des Emitterpotenzials des Transistors T1-A kann so ein unbeabsichtigtes Einschalten des Transistors T1-A verhindert werden.

Um thermische Einflüsse auf das Verhalten der Schaltung zu minimieren, ist es besonders vorteilhaft, die genannten Transistoren T3-A, T3-B, T4-A, T4-B thermisch zu koppeln. Dies kann durch die Verwendung von Bausteinen geschehen, die in einem Gehäuse zwei separate Transistoren enthalten, beispielsweise T3-A und T3-B. Durch diese thermische Kopplung wird erreicht, dass sich temperaturabhängige Parameter, wie zum Beispiel die Schwellspannung der Transistoren, gegenseitig kompensieren.

Die Induktivität L1B ist über die Serienschaltung eines Kondensators C5 und eines Widerstands R6 mit dem Knoten verbunden, mit dem die Anode einer Diode D1 und die Kathode einer Zenerdiode D2 verbunden sind. Durch diesen kapazitiven Abgriff der Induktivität L1B kann die Induktivität L1B als Quelle für eine Ladungspumpe verwendet werden. Sie versorgt die interne Spannungsversorgung mit Energie. Dabei legt die Zenerspannung der Zenerdiode D2 die Versorgungsspannungshöhe fest. Der Kondensator C5 arbeitet dabei als Ladungspumpe, wobei der ladende beziehungsweise entladende Strom des Kondensators C5 in den die Versorgungsspannung U_{I} puffernden Kondensator C2 geleitet wird, wodurch dieser geladen wird. Der zuletzt erwähnte Verbindungspunkt ist überdies über eine Diode D3 mit dem Steueranschluss des Schalttransistors V5 verbunden.

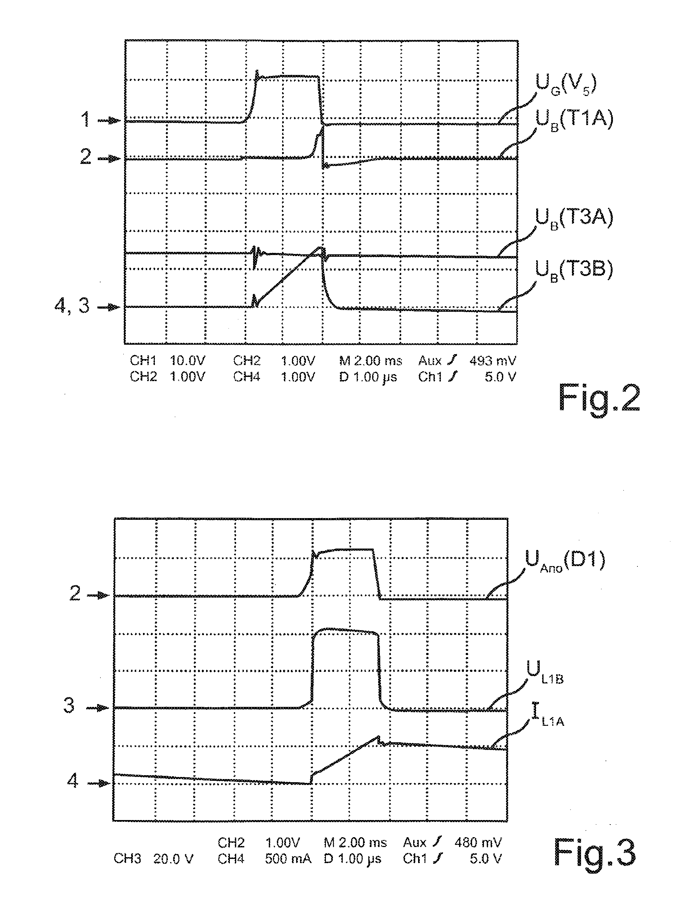

Fig. 2 zeigt den zeitlichen Verlauf der Spannung U_{G}(V5) am Steueranschluss des Schalttransistors V5, die Basisspannung U_{B}(T1A) des Transistors T1-A, die Basisspannung U_{B}(T3A) des Transistors T3-A sowie die Basisspannung U_{B}(T3B) des Transistors T3-B. Es ist darauf hinzuweisen, dass die Nulllinie der Spannungen U_{B}(T3A) und U_{B}(T3B) dieselbe ist, wie durch die Angabe links 4,3 gekennzeichnet.

Sobald der Istwert des Stroms I_{V5} durch den Schalttransistor V5, der dem Verlauf der Spannung U_{B}(T3B) proportional ist, den Schwellwert, repräsentiert durch die Spannung U_{F}(T3A), überschreitet, wird ein Einschaltsignal U_{B}(T1A) an die Basis des Transistors T1-A angelegt. Dadurch wird die Ausschaltvorrichtung 20 aktiviert, wodurch ein Ausschaltsignal U_{G}(V5) an die Steuerelektrode des Schalttransistors V5 angelegt wird. Der Schalttransistor V5 wird dadurch ausgeschaltet.

In dem Augenblick, in dem der Schalttransistor V5 ausgeschaltet wird, kehrt sich die Polarität der Spannung über der Induktivität L1B um. Dies hat zur Folge, dass durch die Ankopplung der Induktivität L1B über den Kondensator C5 und den Widerstand R6 das Potenzial an dem Knoten, mit dem die Anode der Diode D1 und die Kathode der Zenerdiode D2 verbunden sind, auf Null, das heißt Masse, sinkt. Dadurch wird die Diode D3 leitend und hält den Steueranschluss des Schalttransistors V5 auf Massepotenzial.

In dem Augenblick, in dem die Drossel L1A vollständig abmagnetisiert ist, kehrt sich die Polarität der Spannung U_{L1B} über der Induktivität L1B abermals um. Diese Änderung wird über den Kondensator C5 und den ohmschen Widerstand R6 an den Verbindungspunkt der Anode der Diode D1 und der Kathode der Zenerdiode D2 übertragen, wodurch das Potenzial an diesem Knoten wieder auf einen positiven Wert springt. Beschleunigt über eine den Transistor T2 umfassende Verstärkerstufe wird diese Änderung an den Steueranschluss des Schalttransistors V5 übertragen, wodurch dieser wieder eingeschaltet wird.

Fig. 3 zeigt den zeitlichen Verlauf der Spannung U_{Ano} (D1) an der Anode der Diode D1, die Spannung U_{L1B} an der Induktivität L1B sowie des Stroms I_{L1A} durch die Drossel L1A. Deutlich ist zu erkennen, dass in dem Augenblick, in dem der Strom I_{L1A} zu Null wird, die Spannung U_{L1B} der Induktivität L1B langsam zunimmt und das Potenzial an der Anode der Diode D1 entsprechend folgt. Wenn das Potenzial an der Anode der Diode D1, verstärkt durch den Transistor T2, die Einschaltschwelle des Schalttransistors V5 erreicht, schaltet dieser ein. Dadurch steigt die Spannung an der Induktivität L1B und damit die Spannung an der Anode der Diode D1 sowie die Steuerspannung U_{G}(V5) des Schalttransistors V5 schlagartig an (Mitkopplung).

Fig. 4 zeigt in schematischer Darstellung ein zweites Ausführungsbeispiel einer erfindungsgemäßen Schaltungsanordnung. Im Nachfolgenden wird lediglich auf die Unterschiede zu dem in Fig. 1 dargestellten Ausführungsbeispiel eingegangen.

Der wesentliche Unterschied zu dem Ausführungsbeispiel von Fig. 1 besteht darin, dass nunmehr das Drain-Potenzial des Schalttransistors V5 mithilfe eines Koppelkondensators C5 und eines ohmschen Widerstands R6 an die Steuervorrichtung gelegt wird, die den Schalttransistor V5 ein- und ausschaltet. In dem Augenblick, in dem der Schalttransistor V5 durch die Ausschaltvorrichtung 20 ausgeschaltet wird, steigt die Spannung an seinem Drainanschluss an. Dies hat zur Folge, dass durch die Ankopplung über den Kondensator C5 und den Widerstand R6 das Potenzial an dem Knoten, mit dem die Anode der Diode D1 und die Kathode der Zenerdiode D2 verbunden sind, ebenfalls ansteigt. Durch den Anstieg des Potenzials an diesem Knoten bleibt auch der Transistor T2 über die Serienschaltung eines Kondensators C9 und eines ohmschen Widerstands R3 sicher ausgeschaltet.

Wenn die Drossel L1 vollständig abmagnetisiert ist, springt die Spannung am Drainanschluss des Schalttransistors V5 auf den Momentanwert der den Tiefsetzsteller 12 versorgenden Spannung U_{G1}. Dieser Sprung wird über den kapazitiven Koppelpfad, der den Kondensator C5 und den ohmschen Widerstand R6 umfasst, an die Steuervorrichtung übertragen. Dadurch fällt das Potenzial am Verbindungsknoten der Diode D1 und der Zenerdiode D2 vom Niveau der internen Versorgungsspannung auf Massepotenzial. Der Sprung des Potenzials an diesem Verbindungsknoten wird kapazitiv an den Steueranschluss des Transistors T2 geleitet, wodurch dieser eingeschaltet wird. Damit wird der Steueranschluss des Schalttransistors V5 über den Transistor T2 auf das Potenzial der internen Versorgungsspannung U_{I} gelegt. Der Schalttransistor V5 schaltet dadurch ein. Die Diode D6 wird zum Schutz der Basis-Emitterstrecke des Transistors T2 verwendet. Zusätzlich sorgt sie für einen symmetrischen Betrieb des aus C9 und R3 gebildeten RC-Gliedes.

Der ohmsche Widerstand R2 bildet mit dem ohmschen Widerstand R3 einen Spannungsteiler. Dadurch ist die Einstellung einer Mindestsprunghöhe des Potenzials an dem Verbindungspunkt der Diode D1 und der Zenerdiode D2 zum Einschalten des Transistors T2 möglich. Dies führt zu einer Reduktion der Empfindlichkeit des Transistors T2.

Zum Anlauf der Schaltungsanordnung, zu dem ein erstmaliges Einschalten des Schalttransistors V5 erforderlich ist, ist der ohmsche Widerstand R15 vorgesehen. Da nach dem Anlegen der Netzspannung U_{N} an die Schaltungsanordnung noch kein Potenzialsprung am Drain-Potenzial des Schalttransistors V5 existiert, wird sein Gate über den Widerstand R15 aufgeladen bis die Schwellspannung des Schalttransistors V5 erreicht ist. Da das Drain-Potenzial vor dem Einschalten auf dem Niveau der Netzspannung U_{N} liegt, wird durch das Einschalten des Schalttransistors V5 und die kapazitive Kopplung über den Kondensator C9 und den Widerstand R3 der Transistor T2 eingeschaltet (Mitkopplung) und die ansonsten selbst-schwingende Oszillation kann beginnen.

Im selbstschwingenden Betrieb wird zwar das Gate des Schalttransistors V5 ebenfalls über den Widerstand R15 langsam aufgeladen, was theoretisch zu einem unbeabsichtigten Einschalten des Schalttransistors V5 führen könnte, bevor die Drossel L1 abmagnetisiert ist. Durch die Verwendung eines ausreichend großen Widerstandswerts kann dies jedoch verhindert werden. Die Zeitkonstante aus Gate-Kapazität und Widerstand R15 muss dabei größer sein als die im Betrieb maximal auftretende Abmagnetisierungszeit der Drossel L1.

Für den Fall, in dem beispielsweise beim Betrieb mit geringer Eingangsspannung der Schaltungsanordnung das Abmagnetisieren der Drossel L1 von der Steuerschaltung nicht richtig erkannt wird, sorgt die Aufladung des Gates über den Widerstand R15 für ein automatisches Wiederanlaufen der Schaltung und trägt damit zu einer Erhöhung der Zuverlässigkeit der Schaltung bei.

Beim Einschalten des Schalttransistors V5 fließt kurzzeitig ein hoher Strom durch den Schalttransistor V5, da der Kondensator C5 bei jedem Einschalten des Schalttransistors V5 hart entladen werden muss. Durch die Stromerfassung des Source-Stroms würde dieser kurze Strompuls über den oben beschriebenen Komparator 16 zu einem sofortigen Ausschalten des Schalttransistors V5 führen; die Drossel L1 könnte dadurch nicht aufmagnetisiert werden. Zur Unterdrückung dieses ansonsten an den Komparator 16 gelegten Spannungspulses kann ein weiteres RC-Glied, umfassend den Kondensator C10 und den Widerstand R14, verwendet werden. Mithilfe dieses RC-Glieds C10, R14 kann der beim Einschalten des Schalttransistors V5 am Kopplungspunkt der Diode D1 und der Zenerdiode D2 entstehende negative Spannungssprung auf den Eingang des Komparators 16 gekoppelt werden. Dieser unterdrückt dadurch den positiven Sprung am Widerstand R12 (verursacht durch den Spannungsabfall am Widerstand R12).

Zur Spannungsversorgung der Steuervorrichtung wird der den Kondensator C5 ladende Strom verwendet, indem dieser Strom durch die Diode D1 und den Versorgungskondensator C2 geleitet wird, wenn das Drain-Potenzial des Schalttransistors V5 nach dessen Ausschalten ansteigt. Der Kondensator C5 wird also auch hier zusätzlich zu seiner Steuerungsfunktion als Ladungspumpe verwendet. Die neben der Diode D1 erforderliche Diode D2 ist deshalb als Zenerdiode ausgeführt, wobei die Zenerspannung der Zenerdiode D2 die Höhe der internen Versorgungsspannung U_{I} festlegt.

Wenngleich im Vorangegangenen als Beispiel für einen Wandler ein Tiefsetzsteller 12 verwendet wurde, so lässt sich eine erfindungsgemäße Schaltungsanordnung auch mit anderen Wandlern, insbesondere einem Hochsetzsteller, realisieren.

## Patentansprüche

1. Schaltungsanordnung zum Betreiben mindestens einer LED mit
- einem Eingang mit einem ersten und einem zweiten Eingangsanschluss zum Koppeln mit einer Versorgungsgleichspannung (U_{G1});
- einem Ausgang mit einem ersten (P1) und einem zweiten Ausgangsanschluss (P2) zum Koppeln mit der mindestens einen LED;
- einem Spannungswandler (12) mit einer Wandlerdrossel (L1A; L1), einer Wandlerdiode (D5) und einem Wandlerschalter (V5), wobei der Eingang des Spannungswandlers (12) mit dem Eingang der Schaltungsanordnung und der Ausgang des Spannungswandlers (12) mit dem Ausgang (P1, P2) der Schaltungsanordnung gekoppelt ist; und
- einer Steuervorrichtung für den Wandlerschalter (V5), die Folgendes umfasst:
--eine Strommessvorrichtung (14) zur Bereitstellung eines Istwerts des Stroms durch den Wandlerschalter (V5) zumindest während der Zeitdauer der Aufmagnetisierung der Wandlerdrossel (L1A; L1);
--eine Sollwertvorrichtung (18) zur Bereitstellung eines Sollwerts des Stroms durch den Wandlerschalter (V5) zumindest während der Zeitdauer der Aufmagnetisierung der Wandlerdrossel (L1A; L1);
--einen Komparator (16), dem zum einen der Istwert und zum anderen der Sollwert des Stroms durch den Wandlerschalter (V5) zuführbar ist, wobei der Komparator (16) ausgelegt ist, an seinem Ausgang ein Ausschaltsignal bereitzustellen, wenn der Istwert den Sollwert des Stroms durch den Wandlerschalter (V5) übersteigt;
--eine Ausschaltvorrichtung (20) für den Wandlerschalter (V5), wobei die Ausschaltvorrichtung (20) mit dem Ausgang des Komparators (16) gekoppelt und ausgelegt ist, auf ein Ausschaltsignal am Ausgang des Komparators (16) ein Ausschaltsignal für den Wandlerschalter (V5) bereitzustellen; und
--eine Einschaltvorrichtung für den Wandlerschalter (V5), die ausgelegt ist, bei Feststellen einer Abmagnetisierung der Wandlerdrossel (L1A; L1) ein Einschaltsignal für den Wandlerschalter (V5) bereitzustellen,
wobei die Schaltungsanordnung **dadurch gekennzeichnet ist,**
**dass** der Komparator (16) einen Differenzverstärker (T3-A, T3-B) umfasst, wobei die Last des Differenzverstärkers (T3-A, T3-B) einen Stromspiegel (T4-A, T4-B) umfasst, wobei auf der Ausgangsseite des Differenzverstärkers (T3-A, T3-B) zwischen den ausgangsseitigen Schalter (T3-A) des Differenzverstärkers (T3-A, T3-B) und den ausgangsseitigen Schalter (T4-A) des Stromspiegels (T4-A, T4-B) ein erster ohmscher Widerstand (R10) gekoppelt ist, wobei der Ausgang des Komparators (16) mit dem Verbindungspunkt des ausgangsseitigen Schalters (T3-A) des Differenzverstärkers (T3-A, T3-B) und des ersten ohmschen Widerstands (R10) gekoppelt ist.

2. Schaltungsanordnung nach Anspruch 1,
**dadurch gekennzeichnet,**
**dass** die Schaltungsanordnung eine interne Spannungsversorgung (U_{I}), insbesondere mit einer Ladungspumpe, umfasst.

3. Schaltungsanordnung nach Anspruch 2,
**dadurch gekennzeichnet,**
**dass** die Sollwertvorrichtung (18) einen Spannungsteiler (R7, R8) umfasst, der mit der internen Spannungsversorgung (U_{I}) gekoppelt ist, wobei dem Spannungsteiler (R7, R8) eine erste Zenerdiode (D4) parallel geschaltet ist.

4. Schaltungsanordnung nach Anspruch 3,
**dadurch gekennzeichnet,**
**dass** die Nennspannung der ersten Zenerdiode (D4) wie folgt gewählt ist:
- Nennspannung entweder 5,1 V oder 5,6 V; und/oder
- Nennspannung ist kleiner als die interne Versorgungsspannung; und/oder
- Nennspannung ist größer als die Einschaltschwelle des Wandlerschalters.

5. Schaltungsanordnung nach einem der Ansprüche 3 oder 4,
**dadurch gekennzeichnet,**
**dass** dem Ausgang des Spannungsteilers (R7, R8) ein erster Kondensator (C4) parallel geschaltet ist.

6. Schaltungsanordnung nach einem der Ansprüche 2 bis 5, **dadurch gekennzeichnet,**
**dass** zwischen die interne Spannungsversorgung (U_{I}) und den Versorgungsanschluss des Komparators (16) eine Serienschaltung einer zweiten Zenerdiode (V1) und eines zweiten ohmschen Widerstands (R9) gekoppelt ist.

7. Schaltungsanordnung nach Anspruch 6,
**dadurch gekennzeichnet,**
**dass** die Nennspannung der zweiten Zenerdiode (V1) größer ist als die Einschaltschwelle des Wandlerschalters (V5).

8. Schaltungsanordnung nach einem der vorhergehenden Ansprüche,
**dadurch gekennzeichnet,**
**dass** der Wandlerschalter (V5) eine Arbeitselektrode, eine Bezugselektrode und eine Steuerelektrode aufweist, wobei zwischen den ersten Eingangsanschluss der Schaltungsanordnung und die Steuerelektrode des Wandlerschalters (V5) eine Serienschaltung eines dritten ohmschen Widerstands (R1, R13) und eines vierten ohmschen Widerstands (R2; R2, R15) gekoppelt ist.

9. Schaltungsanordnung nach einem der vorhergehenden Ansprüche,
**dadurch gekennzeichnet,**
**dass** die Ausschaltvorrichtung (20) als Komplementär-Darlingtonschaltung mit einem ersten (T1-A) und einem zweiten Transistor (T1-B) ausgebildet ist, wobei die Steuerelektrode eines ersten Transistors (T1-A) mit dem Ausgang des Komparators (16) gekoppelt ist, wobei die Bezugselektrode des zweiten Transistors (T1-B) mit dem Ausgang der Ausschaltvorrichtung (20) gekoppelt ist, wobei die Steuerelektrode des zweiten Transistors (T1-B) mit der Arbeitselektrode des ersten Transistors (T1-A) gekoppelt ist, wobei zwischen die Bezugselektrode und die Steuerelektrode des zweiten Transistors (T1-B) ein zweiter Kondensator (C3) gekoppelt ist.

10. Schaltungsanordnung nach einem der Ansprüche 2 bis 9,
**dadurch gekennzeichnet,**
**dass** der internen Spannungsversorgung (U_{I}) die Serienschaltung einer ersten Diode (D1) und einer dritten Zenerdiode (D2) parallel geschaltet ist.

11. Schaltungsanordnung nach Anspruch 10,
**dadurch gekennzeichnet,**
**dass** zwischen eine Quelle für die interne Spannungsversorgung (U_{I}) und den Verbindungspunkt der ersten Diode (D1) und der dritten Zenerdiode (D2) als Ladungspumpe die Serienschaltung eines dritten Kondensators (C5) und eines fünften ohmschen Widerstands (R6) gekoppelt ist.

12. Schaltungsanordnung nach einem der Ansprüche 2 bis 11,
**dadurch gekennzeichnet,**
**dass** die Steuervorrichtung eine zweite Induktivität (L1B) umfasst, die mit der Wandlerdrossel (L1A; L1) magnetisch gekoppelt ist, wobei die zweite Induktivität (L1B) eine Quelle einer Ladungspumpe für die interne Spannungsversorgung (U_{I}) darstellt.

13. Schaltungsanordnung nach einem der Ansprüche 11 oder 12,
**dadurch gekennzeichnet,**
**dass** sie einen dritten Transistor (T2) umfasst, wobei die Steuerelektrode des dritten Transistors (T2) mit dem Verbindungspunkt der Serienschaltung aus dem dritten Kondensator (C5) und dem fünften ohmschem Widerstand (R6) gekoppelt ist, wobei die Arbeitselektrode des dritten Transistors (T2) mit der internen Spannungsversorgung (U_{I}) gekoppelt ist, wobei die Bezugselektrode des dritten Transistors (T2) mit der Steuerelektrode des Wandlerschalters (V5) gekoppelt ist.

14. Schaltungsanordnung nach Anspruch 13,
**dadurch gekennzeichnet,**
**dass** der Verbindungspunkt der ersten Diode (D1) und der dritten Zenerdiode (D2) mit dem Verbindungspunkt des Ausgangs der Ausschaltvorrichtung (20) und der Steuerelektrode des dritten Transistors (T2) gekoppelt ist.

15. Schaltungsanordnung nach einem der Ansprüche 2 bis 11,
**dadurch gekennzeichnet,**
**dass** die Arbeitselektrode des Wandlerschalters (V5) die Quelle einer Ladungspumpe für die interne Spannungsversorgung (U_{I}) darstellt.

16. Schaltungsanordnung nach Anspruch 15,
**dadurch gekennzeichnet,**
**dass** der Verbindungspunkt der ersten Diode (D1) und der dritten Zenerdiode (D2) über zumindest einen vierten Kondensator (C9) mit der Steuerelektrode eines dritten Transistors (T2) gekoppelt ist, wobei die Arbeitselektrode des dritten Transistors (T2) mit der Steuerelektrode des Wandlerschalters (V5) gekoppelt ist, wobei die Bezugselektrode des dritten Transistors (T2) mit der internen Spannungsversorgung (U_{I}) gekoppelt ist.

17. Schaltungsanordnung nach Anspruch 16,
**dadurch gekennzeichnet,**
**dass** zwischen die interne Spannungsversorgung (U_{I}) und die Steuerelektrode des dritten Transistors (T2) eine dritte Diode (D6) und/oder ein Anteil (R2) des vierten ohmschen Widerstands (R2, R15) gekoppelt ist.

18. Schaltungsanordnung nach einem der Ansprüche 16 oder 17, -
**dadurch gekennzeichnet,**
**dass** der Wandlerschalter (V5) eine Steuerelektroden-Kapazität aufweist, wobei die Zeitkonstante aus der Steuerelektroden-Kapazität und dem Anteil (R15) des vierten ohmschen Widerstands (R2, R15), über den die Steuerelektrode des Wandlerschalters (V5) mit der internen Spannungsversorgung (U_{I}) gekoppelt ist, größer ist als die maximale, im Betrieb auftretende Abmagnetisierungszeit der Wandlerdrossel (L1A, L1).

19. Schaltungsanordnung nach einem der Ansprüche 16 bis 18,
**dadurch gekennzeichnet,**
**dass** der Verbindungspunkt der ersten Diode (D1) und der dritten Zenerdiode (D2) über die Serienschaltung eines fünften Kondensators (C10) und eines sechsten ohmschen Widerstands (R14) mit dem Eingang des Komparators (16) gekoppelt ist, über den der Istwert des Stroms durch den Wandlerschalter (V5) zuführbar ist.

## Claims

1. Circuit arrangement for operating at least one LED comprising
- an input having a first and a second input terminal for coupling to a DC supply voltage (U_{Gl});
- an output having a first (P1) and a second output terminal (P2) for coupling to the at least one LED;
- a voltage converter (12) having a converter inductor (L1A; L1), a converter diode (D5) and a converter switch (V5), wherein the input of the voltage converter (12) is coupled to the input of the circuit arrangement and the output of the voltage converter (12) is coupled to the output (P1, P2) of the circuit arrangement; and
- a control device for the converter switch (V5), said control device comprising the following:
-- a current measuring device (14) for providing an actual value of the current through the converter switch (V5) at least during the time duration of the magnetization of the converter inductor (L1A; L1);
-- a setpoint value device (18) for providing a setpoint value of the current through the converter switch (V5) at least during the time duration of the magnetization of the converter inductor (L1A; L1);
-- a comparator (16), to which firstly the actual value and secondly the setpoint value of the current through the converter switch (V5) can be fed, wherein the comparator (16) is designed to provide a switch-off signal at its output if the actual value exceeds the setpoint value of the current through the converter switch (V5);
-- a switch-off device (20) for the converter switch (V5), wherein the switch-off device (20) is coupled to the output of the comparator (16) and designed to provide a switch-off signal for the converter switch (V5) in response to a switch-off signal at the output of the comparator (16); and
-- a switch-on device for the converter switch (V5), said switch-on device being designed to provide a switch-on signal for the converter switch (V5) upon a demagnetization of the converter inductor (L1A; L1) being ascertained,
wherein the circuit arrangement is **characterized in that** the comparator (16) comprises a differential amplifier (T3-A, T3-B), wherein the load of the differential amplifier (T3-A, T3-B) comprises a current mirror (T4-A, T4-B), wherein a first ohmic resistor (R10) is coupled on the output side of the differential amplifier (T3-A, T3B) between the output-side switch (T3-A) of the differential amplifier (T3-A, T3-B) and the output-side switch (T4-A) of the current mirror (T4-A, T4-B), wherein the output of the comparator (16) is coupled to the junction point between the output-side switch (T3-A) of the differential amplifier (T3-A, T3-B) and the first ohmic resistor (R10).

2. Circuit arrangement according to Claim 1,
**characterized**
**in that** the circuit arrangement comprises an internal voltage supply (U_{I}), in particular with a charge pump.

3. Circuit arrangement according to Claim 2,
**characterized**
**in that** the setpoint value device (18) comprises a voltage divider (R7, R8) coupled to the internal voltage supply (U_{I}), wherein a first zener diode (D4) is connected in parallel with the voltage divider (R7, R8).

4. Circuit arrangement according to Claim 3,
**characterized**
**in that** the rated voltage of the first zener diode (D4) is chosen as follows:
- rated voltage either 5.1 V or 5.6 V; and/or
- rated voltage is less than the internal supply voltage; and/or
- rated voltage is greater than the switch-on threshold of the converter switch.

5. Circuit arrangement according to either of Claims 3 and 4,
**characterized**
**in that** a first capacitor (C4) is connected in parallel with the output of the voltage divider (R7, R8).

6. Circuit arrangement according to any of Claims 2 to 5,
**characterized**
**in that** a series circuit formed by a second zener diode (V1) and a second ohmic resistor (R9) is coupled between the internal voltage supply (U_{I}) and the supply terminal of the comparator (16).

7. Circuit arrangement according to Claim 6,
**characterized in that**
the rated voltage of the second zener diode (V1) is greater than the switch-on threshold of the converter switch (V5).

8. Circuit arrangement according to any of the preceding Claims,
**characterized**
**in that** the converter switch (V5) has an operating electrode, a reference electrode and a control electrode, wherein a series circuit formed by a third ohmic resistor (R1, R13) and a fourth ohmic resistor (R2; R2, R15) is coupled between the first input terminal of the circuit arrangement and the control electrode of the converter switch (V5).

9. Circuit arrangement according to any of the preceding Claims,
**characterized**
**in that** the switch-off device (20) is embodied as a complementary Darlington circuit having a first (T1-A) and a second transistor (T1-B), wherein the control electrode of a first transistor (T1-A) is coupled to the output of the comparator (16), wherein the reference electrode of the second transistor (T1-B) is coupled to the output of the switch-off device (20), wherein the control electrode of the second transistor (T1-B) is coupled to the operating electrode of the first transistor (T1-A), wherein a second capacitor (C3) is coupled between the reference electrode and the control electrode of the second transistor (T1-B).

10. Circuit arrangement according to any of Claims 2 to 9,
**characterized**
**in that** the series circuit formed by a first diode (D1) and a third zener diode (D2) is connected in parallel with the internal voltage supply (U_{I}).

11. Circuit arrangement according to Claim 10,
**characterized**
**in that** the series circuit formed by a third capacitor (C5) and a fifth ohmic resistor (R6) is coupled between a source for the internal voltage supply (U_{I}) and the junction point between the first diode (D1) and the third zener diode (D2) as a charge pump.

12. Circuit arrangement according to any of Claims 2 to 11,
**characterized**
**in that** the control device comprises a second inductance (L1B), which is magnetically coupled to the converter inductor (L1A; L1), wherein the second inductance (L1B) constitutes a source of a charge pump for the internal voltage supply (U_{I}).

13. Circuit arrangement according to either of Claims 11 and 12,
**characterized**
**in that** it comprises a third transistor (T2), wherein the control electrode of the third transistor (T2) is coupled to the junction point of the series circuit formed by the third capacitor (C5) and the fifth ohmic resistor (R6), wherein the operating electrode of the third transistor (T2) is coupled to the internal voltage supply (U_{I}), wherein the reference electrode of the third transistor (T2) is coupled to the control electrode of the converter switch (V5).

14. Circuit arrangement according to Claim 13,
**characterized**
**in that** the junction point between the first diode (D1) and the third zener diode (D2) is coupled to the junction point between the output of the switch-off device (20) and the control electrode of the third transistor (T2).

15. Circuit arrangement according to any of Claims 2 to 11,
**characterized**
**in that** the operating electrode of the converter switch (V5) constitutes the source of a charge pump for the internal voltage supply (U_{I}).

16. Circuit arrangement according to Claim 15,
**characterized**
**in that** the junction point between the first diode (D1) and the third zener diode (D2) is coupled to the control electrode of a third transistor (T2) via at least one fourth capacitor (C9), wherein the operating electrode of the third transistor (T2) is coupled to the control electrode of the converter switch (V5), wherein the reference electrode of the third transistor (T2) is coupled to the internal voltage supply (U_{I}).

17. Circuit arrangement according to Claim 16,
**characterized**
**in that** a third diode (D6) and/or a portion (R2) of the fourth ohmic resistor (R2, R15) are/is coupled between the internal voltage supply (U_{I}) and the control electrode of the third transistor (T2).

18. Circuit arrangement according to either of Claims 16 and 17,
**characterized**
**in that** the converter switch (V5) has a control electrode capacitance, wherein the time constant formed from the control electrode capacitance and the portion (R15) of the fourth ohmic resistor (R2, R15) via which the control electrode of the converter switch (V5) is coupled to the internal voltage supply (U_{I}) is greater than the maximum demagnetization time of the converter inductor (L1A, L1) that occurs during operation.

19. Circuit arrangement according to any of Claims 16 to 18,
**characterized**
**in that** the junction point between the first diode (D1) and the third zener diode (D2) is coupled via the series circuit formed by a fifth capacitor (C10) and a sixth ohmic resistor (R14) to the input of the comparator (16), via which the actual value of the current through the converter switch (V5) can be fed.

## Revendications

1. Circuit pour faire fonctionner au moins une diode électroluminescente (DEL) comportant
- une entrée avec une première et une deuxième borne d'entrée destinées à être couplées à une tension d'alimentation continue (U_{gl}) ; ;
- une sortie avec une première (P1) et une deuxième borne de sortie (P2) destinées à être couplées à la au moins une DEL ;
- un convertisseur de tension (12) avec une bobine de convertisseur (L1A ; L1), une diode de convertisseur (D5) et un commutateur de convertisseur (V5), l'entrée du convertisseur de tension (12) étant couplée à l'entrée du circuit et la sortie du convertisseur de tension (12) à la sortie (P1, P2) du circuit ; et
- un dispositif de commande pour le commutateur de convertisseur (V5), qui comprend :
-- un dispositif de mesure du courant (14) destiné à fournir une valeur réelle du courant à travers le commutateur de convertisseur (V5) au moins pendant la durée de la magnétisation de la bobine de convertisseur (L1A ; L1) ;
-- un dispositif (18) destiné à fournir une valeur de consigne du courant à travers le commutateur de convertisseur (V5) au moins pendant la durée de la magnétisation de la bobine de convertisseur (L1A ; L1) ;
-- un comparateur (16) auquel peut être amenée, d'une part, la valeur réelle et, d'autre part, la valeur de consigne du courant à travers le commutateur de convertisseur (V5), le comparateur (16) étant adapté pour fournir à sa sortie un signal de désactivation lorsque la valeur réelle dépasse la valeur de consigne du courant à travers le commutateur de convertisseur (V5) ;
-- un dispositif de désactivation (20) pour le commutateur de convertisseur (V5), le dispositif de désactivation (20) étant couplé à la sortie du comparateur (16) et adapté pour fournir, suite à un signal de désactivation à la sortie du comparateur (16), un signal de désactivation pour le commutateur de convertisseur (V5) ; et
-- un dispositif d'activation pour le commutateur de convertisseur (V5), adapté pour fournir un signal d'activation pour le commutateur de convertisseur (V5) quand une démagnétisation de la bobine de convertisseur (L1A ; L1) est constatée,
le circuit étant **caractérisé en ce que**
le comparateur (16) comprend un amplificateur différentiel (T3-A, T3-B), la charge de l'amplificateur différentiel (T3-A, T3-B) comprenant un miroir de courant (T4-A, T4-B), sur le côté sortie de l'amplificateur différentiel (T3-A, T3-B) une première résistance ohmique (R10) étant couplée entre le commutateur (T3-A) côté sortie de l'amplificateur différentiel (T3-A, T3-B) et le commutateur (T4-A) côté sortie du miroir de courant (T4-A, T4-B), la sortie du comparateur (16) étant couplée au point de jonction du commutateur (T3-A) côté sortie de l'amplificateur différentiel (T3-A, T3-B) et de la première résistance ohmique (R10).

2. Circuit selon la revendication 1,
**caractérisé en ce que**
le circuit comprend une alimentation en tension interne (U_{I}), notamment avec une pompe de charge.

3. Circuit selon la revendication 2,
**caractérisé en ce que**
le dispositif (18) destiné à fournir une valeur de consigne comprend un diviseur de tension (R7, R8) couplé à l'alimentation en tension interne (U_{I}), le diviseur de tension (R7, R8) étant connecté en parallèle avec une première diode Zener (D4).

4. Circuit selon la revendication 3,
**caractérisé en ce que**
la tension nominale de la première diode Zener (D4) est choisie comme suit :
- tension nominale soit 5,1 V soit 5,6 V ; et/ou
- tension nominale inférieure à la tension d'alimentation interne ; et/ou
- tension nominale supérieure au seuil d'activation du commutateur de convertisseur.

5. Circuit selon l'une des revendications 3 ou 4,
**caractérisé en ce que**
la sortie du diviseur de tension (R7, R8) est connectée en parallèle avec un premier condensateur (C4).

6. Circuit selon l'une des revendications 2 à 5,
**caractérisé en ce que**
un montage en série d'une deuxième diode Zener (V1) et d'une deuxième résistance ohmique (R9) est couplé entre l'alimentation interne (U_{I}) et la borne d'alimentation du comparateur (16).

7. Circuit selon la revendication 6,
**caractérisé en ce que**
la tension nominale de la deuxième diode Zener (V1) est supérieure au seuil d'activation du commutateur de convertisseur (V5).

8. Circuit selon l'une des revendications précédentes,
**caractérisé en ce que**
le commutateur de convertisseur (V5) présente une électrode de travail, une électrode de référence et une électrode de commande, un montage en série d'une troisième résistance ohmique (R1, R13) et d'une quatrième résistance ohmique (R2 ; R2, R15) étant couplé entre la première borne d'entrée du circuit et l'électrode de commande du commutateur de convertisseur (V5).

9. Circuit selon l'une des revendications précédentes,
**caractérisé en ce que**
le dispositif de désactivation (20) est réalisé comme un circuit de Darlington complémentaire ayant un premier (T1-A) et un deuxième transistor (T1-B), l'électrode de commande du premier transistor (T1-A) étant couplée à la sortie du comparateur (16), l'électrode de référence du deuxième transistor (T1-B) étant couplée à la sortie du dispositif de désactivation (20), l'électrode de commande du deuxième transistor (T1-B) étant couplée à l'électrode de travail du premier transistor (T1-A), un deuxième condensateur (C3) étant couplé entre l'électrode de référence et l'électrode de commande du deuxième transistor (T1-B).

10. Circuit selon l'une des revendications 2 à 9,
**caractérisé en ce que**
l'alimentation en tension interne (U_{I}) est connectée en parallèle avec le montage en série d'une première diode (D1) et d'une troisième diode Zener (D2).

11. Circuit selon la revendication 10,
**caractérisé en ce que**
le montage en série d'un troisième condensateur (C5) et d'une cinquième résistance ohmique (R6) est couplé en tant que pompe de charge entre une source pour l'alimentation en tension interne (U_{I}) et le point de jonction de la première diode (D1) et de la troisième diode Zener (D2).

12. Circuit selon l'une des revendications 2 à 11,
**caractérisé en ce que**
le dispositif de commande comprend une deuxième inductance (L1B) couplée magnétiquement à la bobine de convertisseur (L1A ; L1), la deuxième inductance (L1B) constituant une source d'une pompe de charge pour l'alimentation en tension interne (U_{I}).

13. Circuit selon l'une des revendications 11 ou 12,
**caractérisé en ce que**
il comprend un troisième transistor (T2), l'électrode de commande du troisième transistor (T2) étant couplée au point de jonction du montage en série constitué du troisième condensateur (C5) et de la cinquième résistance ohmique (R6), l'électrode de travail du troisième transistor (T2) étant couplée à l'alimentation en tension interne (U_{I}), l'électrode de référence du troisième transistor (T2) étant couplée à l'électrode de commande du commutateur de convertisseur (V5).

14. Circuit selon la revendication 13,
**caractérisé en ce que**
le point de jonction de la première diode (D1) et de la troisième diode Zener (D2) est couplé au point de jonction de la sortie du dispositif de désactivation (20) et de l'électrode de commande du troisième transistor (T2).

15. Circuit selon l'une des revendications 2 à 11,
**caractérisé en ce que**
l'électrode de travail du commutateur de convertisseur (V5) constitue la source d'une pompe de charge pour l'alimentation en tension interne (U_{I}).

16. Circuit selon la revendication 15,
**caractérisé en ce que**
le point de jonction de la première diode (D1) et de la troisième diode Zener (D2) est couplé via au moins un quatrième condensateur (C9) à l'électrode de commande d'un troisième transistor (T2), l'électrode de travail du troisième transistor (T2) étant couplée à l'électrode de commande du commutateur de convertisseur (V5), l'électrode de référence du troisième transistor (T2) étant couplée à l'alimentation en tension interne (U_{I}).

17. Circuit selon la revendication 16,
**caractérisé en ce que**
une troisième diode (D6) et/ou une part (R2) de la quatrième résistance ohmique (R2, R15) est couplée entre l'alimentation en tension interne (U_{I}) et l'électrode de commande du troisième transistor (T2).

18. Circuit selon l'une des revendications 16 ou 17,
**caractérisé en ce que**
le commutateur de convertisseur (V5) présente une capacité d'électrode de commande, la constante de temps calculée à partir de la capacité d'électrode de commande et la part (R15) de la quatrième résistance ohmique (R2, R15) via laquelle l'électrode de commande du commutateur de convertisseur (V5) est couplée à l'alimentation en tension interne (U_{I}), est supérieure au temps de magnétisation maximal pouvant apparaître pendant le fonctionnement de la bobine de convertisseur (L1A, L1).

19. Circuit selon l'une des revendications 16 à 18,
**caractérisé en ce que**
le point de jonction de la première diode (D1) et de la troisième diode Zener (D2) est couplé via le montage en série d'un cinquième condensateur (C10) et d'une sixième résistance ohmique (R14) à l'entrée du comparateur (16) via laquelle la valeur réelle du courant à travers le commutateur de convertisseur (V5) peut être amenée.
